Europäisches Patentamt

(19) European Patent Office

Office européen des brevets

(11) Numéro de publication: **0 243 270 B1**

## (12) FASCICULE DE BREVET EUROPEEN

(45) Date de publication du fascicule du brevet:
**04.07.90**

(51) Int. Cl.⁵: **G01R 33/38**

(21) Numéro de dépôt: **87400925.1**

(22) Date de dépôt: **22.04.87**

(54) **Système de bobines pour la production de gradients de champs magnétiques de polarisation très uniformes dans une installation d'imagerie ou de spectroscopie par RMN.**

(30) Priorité: **24.04.86 FR 8605963**

(43) Date de publication de la demande:
**28.10.87 Bulletin 87/44**

(45) Mention de la délivrance du brevet:
**04.07.90 Bulletin 90/27**

(84) Etats contractants désignés:
**DE GB NL**

(56) Documents cités:
**EP-A- 0 073 402**
**EP-A- 0 140 259**
**JP-A-61 085 803**

(73) Titulaire: **COMMISSARIAT A L'ENERGIE ATOMIQUE,
31/33, rue de la Fédération, F-75015 Paris(FR)**

(72) Inventeur: **Briguet, André, 14, Avenue Condorcet,
F-69100 Villeurbanne(FR)**
Inventeur: **Chaillout, Jean-Jacques, Lotissement "Le
Montagnier Haut", F-38960 Saint Etienne de
Crossey(FR)**
Inventeur: **Jeandey, Christian, Chemin Fiancey Le Muret,
F-38120 Saint Egreve(FR)**

(74) Mandataire: **Mongrédien, André et al, c/o
BREVATOME 25, rue de Ponthieu, F-75008 Paris(FR)**

## Description

La présente invention se rapporte au domaine de l'imagerie, de la spectroscopie, ou de l'imagerie spectroscopique par résonance magnétique nucléaire, d'un milieu à examiner.

La présente invention s'applique notamment pour l'imagerie du corps humain par résonance magnétique nucléaire (RMN) dont elle permet d'obtenir des images d'une qualité et d'une précision inconnues jusqu'ici avec les méthodes de la radiologie classique aux rayons X. Elle s'applique plus particulièrement encore à la phase de construction de l'image ainsi obtenue par codage spatial et calcul à l'aide d'un ordinateur.

La méthode d'imagerie RMN utilise la propriété de résonance magnétique nucléaire de certains noyaux présents dans le corps humain, essentiellement les protons répartis dans tout l'organisme, et quelques noyaux d'intérêt biologique mais en abondance beaucoup moins grande tel que le phosphore $^{31}$P, le potassium $^{39}$K, le sodium $^{23}$Na. Elle permet, en dressant la carte de leur concentration en chaque point du volume examiné, de fabriquer des images des tissus vivants, notamment à partir de l'hydrogène contenu dans l'eau et des lipides qui sont des composants essentiels de toute matière vivante.

Une installation de RMN médicale se compose principalement d'un aimant destiné à produire dans toute la zone du corps à examiner un champ magnétique de polarisation $\vec{B}o$, statique et uniforme, auquel on superpose, à l'aide d'une bobine auxiliaire, des impulsions de champ de radiofréquence dans un plan perpendiculaire à la direction du champ $\vec{B}o$ précédent.

Les images ou les renseignements de nature spectroscopiques sont obtenus en faisant résonner le plus souvent des noyaux d'hydrogène ou protons, contenus dans les tissus biologiques. Le signal des résonances détectées au cours du retour à l'équilibre en précession libre des spins excités par le champ de radiofréquence à la fréquence de Larmor est proportionnel à l'aimantation $\vec{M}$ des noyaux placés dans le champ magnétique $\vec{B}o$ de polarisation. Si le champ continu de polarisation $\vec{B}o$ est parfaitement homogène, tous les vecteurs aimantation $\vec{M}$ issus des différents points du volume à imager ou à examiner sont en phase et il est impossible dans le signal global reçu

$$s(t) = \iiint_{xyz} M(x,y,z)e^{-t/T2}dx\ dy\ dz$$

d'attribuer à chaque point une fréquence et une intensité particulières. Pour parvenir à identifier la contribution à ce signal global de chaque volume élémentaire, on réalise un codage en fréquence de l'espace à examiner en superposant au champ $\vec{B}o$ des champs additionnels Bz(x), Bz(y), Bz(z) variant linéairement suivant l'une des coordonnées de sorte que la composante du champ de polarisation $\vec{B}o + \vec{B}z$ selon Oz a des gradients spatiaux : $\delta Bz/\delta x$, $\delta Bz/\delta y$ et $\delta Bz/\delta z$ constants selon les directions x, y et z, et satisfaisant les trois égalités suivantes :

$$Bz(x) = \frac{\partial Bz}{\partial x} \cdot x = Gx \cdot x$$

$$Bz(y) = \frac{\partial Bz}{\partial y} \cdot y = Gy \cdot y$$

$$Be(z) = \frac{\partial Bz}{\partial z} \cdot z = Gz \cdot z$$

dans lesquelles Gx, Gy, Gz sont les trois gradients constants de l'induction résultante selon Ox, Oy et Oz. L'usage à prévalu en imagerie par RMN d'appeler, de façon impropre, ces champs additionnels "gradients linéaires" ("linear gradients") et nous nous conformerons à cet usage dans la suite du présent texte.

Des méthodes connues utilisant toute la transformation de Fourier permettent, à partir de ces gradients linéaires, une transposition "fréquence-espace" et, par là même, la construction par ordinateur des images du corps à étudier.

La présente invention s'applique tout particulièrement, dans le cas d'installations fonctionnant à l'aide d'aimants d'accès "axial" et produisant un champ "axial", c'est-à-dire dans lesquels le corps à examiner ou à spectroscopier est de forme allongée et s'étend selon l'axe Oz du champ de polarisation.

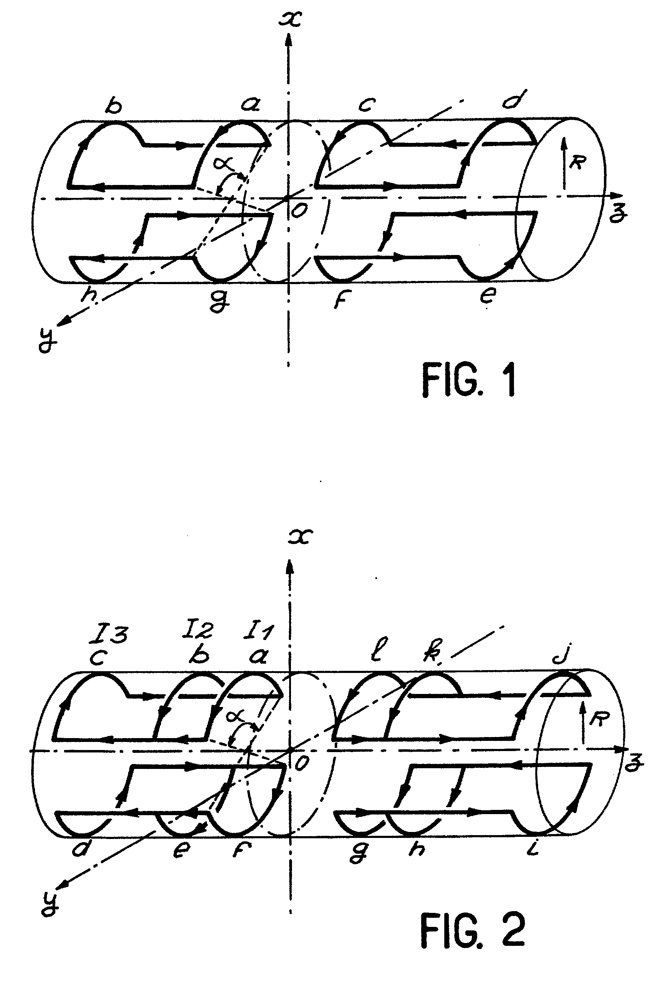

A titre d'exemple de l'art connu, on a représenté sur les figures 1 et 2 ci-jointes des modes de mise en oeuvre de bobinages destinés à la production des gradients transversaux Gx et Gy de lecture du résultat dans une installation de résonance magnétique nucléaire à configuration axiale, dans laquelle le champ de polarisation est dirigé selon la direction Oz. De tels systèmes connus sous le nom de bobinage de Golay sont d'ailleurs dècrits notamment dans le brevet américain US-A-4 486 711 déposé le 4 décembre 1984.

Dans ces structures de configuration cylindrique, les bobinages de production des gradients de champ Gx et Gy sont tracés à la surface d'un cylindre de rayons R, d'axe Oz, et ont la forme de selles de cheval à un (figure 1) ou deux conducteurs d'aller (figure 2). Si l'on adopte l'orientation spatiale Ox, Oy, Oz des figures 1 et 2, les bobinages précédents qui comportent les arcs de courant a, b, c, d, e, f, g, h pour la figure 1 et a, b, c, d, e, f, g, h, j, k, l pour la figure 2 permet d'obtenir les gradients linéaires selon les directions Ox et Oy perpendiculaires à la direction générale Oz du champ de polarisation $\vec{Bo}$. Dans le cas de la figure 2, le courant de retour $I_3$ est égal à la somme des courants d'aller $I_1+I_2$, puisqu'il s'agit de cadres rectangulaires fermés.

La figure 1 représente un système de bobines de Golay produisant un gradient Gx mais il est évident qu'une rotation de 90° de tout le système autour de Oz conduirait aussi bien à un système de gradients selon la direction Oy. Il en est de même pour le dispositif de la figure 2.

On obtient respectivement une variation relative du gradient de champ dans la direction Ox inférieure à ± 1% dans une sphère de rayon 0,2 R (R étant le rayon de support des bobinages) pour le système de la figure 1, et 0,3 R pour le système de la figure 2.

Pour des raisons fondamentales, liées à la technique d'imagerie par RMN, la variation du champ magnétique délivré par un système de gradients linéaires doit être effectivement linéaire avec la coordonnée spatiale x ou y. Malheureusement, les systèmes habituellement construits tels que les systèmes de Golay qui viennent d'être rappelés ne répondent à cette condition que de manière approchée. C'est ainsi que, dans les systèmes connus actuels, on peut considérer que la région où le gradient de lecture créé par les systèmes de bobines précédents est uniforme à ± 1% près, est une sphère de rayon égal au tiers du rayon R du support des fils des bobines de gradient. Ceci signifie que le domaine de l'espace autour de l'axe Oz dans lequel il est possible d'obtenir des images ou des renseignements spectroscopiques de bonne qualité est relativement limité et ne dépasse pas en général le tiers du rayon de l'installation des bobines de gradient.

Il est donc très important de pouvoir augmenter le volume dans lequel le gradient de champ de polarisation est uniforme car une telle augmentation procure au moins les trois avantages suivants :

- le rayon R du support des bobines de gradient étant donné, le volume des échantillons étudiables par la technique de résonance magnétique nucléaire appliquée (imagerie, spectroscopie) est augmenté également;

- pour un volume d'échantillon donné, il est avec un aimant particulier, possible d'employer des bobines de gradient de diamètre réduit par rapport à celui des bobines classiques. Ceci permet de diminuer le couplage entre les bobines de gradient et l'aimant et de permettre des vitesses de commutation de gradient les plus élevées possibles en imagerie et en imagerie spectroscopique,

- un autre avantage de la possibilité d'utiliser des bobines de gradient de diamètre réduit, réside dans le fait que la puissance de commutation nécessaire à l'établissement des gradients croît très vite avec le rayon et qu'elle est pratiquement proportionnelle à la puissance 5 ($R^5$) de ce dernier.

L'étude mathématique du développement analytique de l'expression du champ magnétique créé par des bobines de gradient tansversal peut être faite à l'aide de la méthode des polynômes de Legendre et fait appel aux fonctions de Legendre d'ordre l et de degré m, associés aux polynômes de Legendre d'ordre I. Ce développement analytique est compliqué puisque chaque ordre est représenté par plusieurs termes du développement. Toutefois, on démontre que la suppression des termes d'ordre impair et notamment les termes d'ordre 3 et 5 confère au champ magnétique créé par les bobines correspondantes une excellente linéarité spatiale. La suppression totale des termes d'ordre 3 et 5 qui serait une situation idéale, suppose que l'on soit capable de réaliser l'élimination des différents degrés correspondants, lesquels sont respectivement au nombre de 4 et 6.

C'est ce que permet précisément d'obtenir le système de bobines conformes à l'invention, qui comporte des formes d'enroulements réalisables sur une surface en forme de cylindre, capables de créer un gradient transversal par rapport à l'axe de ce cylindre et totalement corrigé des termes d'ordre 3 et 5 du développement analytique en polynômes de Legendre. Selon l'invention, deux structures proposées réalisent cette condition et une troisième structure, nettement plus simple, s'en approche suffisamment pour que la linéarité des gradients obtenus soit encore très acceptable.

Dans tout le présent texte, pour simplifier l'exposé et la présentation des revendications, on décrit explicitement la production, dans une structure axiale d'axe Oz parallèle au champ de polarisation $\vec{Bo}$, de gradients Gx et Gy de champs magnétiques selon une des directions Ox et Oy perpendiculaires au champ de polarisation. Il doit cependant être entendu, comme cela est d'ailleurs à la portée de l'homme de l'Art, que les bobines objet de l'invention permettent aussi bien la production d'un gradient Gz lorsque le champ de polarisation $\vec{Bo}$ est dirigé selon Ox, c'est-à-dire transverse par rapport à l'axe du cylindre droit.

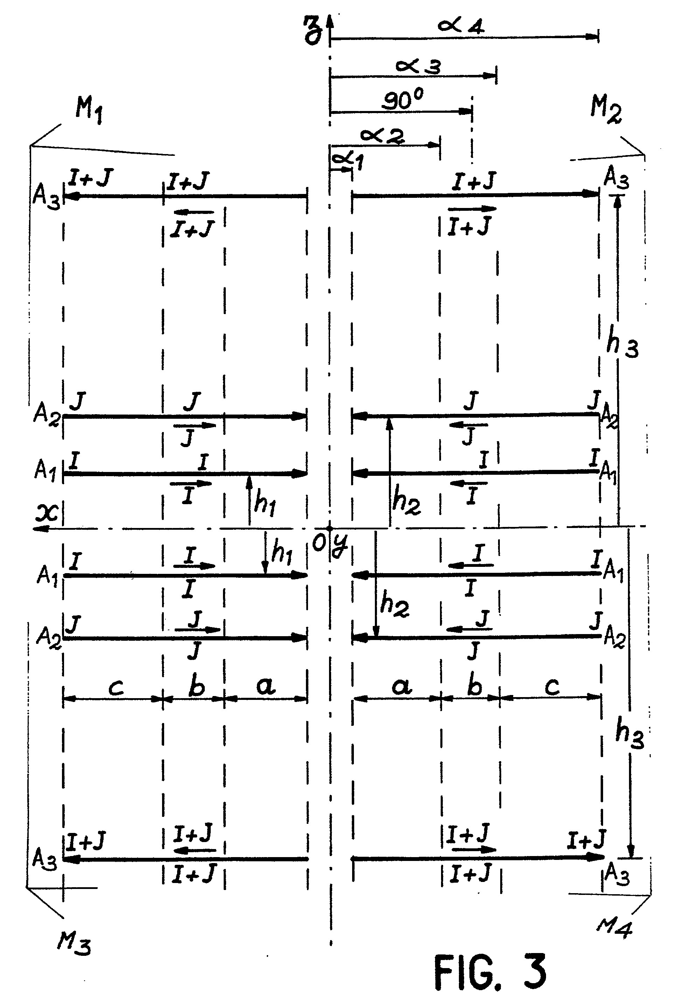

Ce système de bobines, pour la production en imagerie, en spectroscopie ou en imagerie spectroscopique par résonance magnétique nucléaire de gradients $G_x$, $G_y$ de champs magnétiques de polarisation très uniformes selon une direction perpendiculaire (Ox ou Oy) au champ magnétique de polarisation créé dans la direction Oz par un aimant d'accès axial, ledit système de bobines étant disposé sur la surface externe d'un cylindre droit de révolution d'axe Oz et de rayon R selon le schéma des figures 3 à 9 qui sont des représentations planes et développées de cette surface externe du cylindre droit supposée fendue selon une génératrice de direction Oz, comprenont quatre motifs de fils conducteurs symétriques deux à deux par rapport à un centre 0 et deux à deux par rapport au plan vertical xoy, chaque motif comportant des arcs ou lignes de courant disposés selon des portions de sections circulaires du cylindre droit caractérisé par la répartition suivante:
- chaque motif comporte trois arcs participant à la création du gradient recherché, à savoir deux arcs "aller" situés près du centre 0 aux distances respectives $h_1$ et $h_2$ du plan xoy et un arc "retour" plus éloigné du centre 0 et situé à la distance $h_3$ du plan xoy ;
- chaque arc comporte trois sections a, b, c dont les deux extrêmes a et c d'égale longueur sont parcourues par un courant d'intensité moitié de celui qui parcourt la section centrale b, les courants "aller" dans la première section des deux premiers arcs étant égaux respectivement à I et J et le courant "retour" dans la première section du troisième arc étant égal à I+J ;
- en ce que les rapports $h_1/R$, $h_2/R$ et $h_3/R$ sont choisis aussi proches que possible des valeurs du tableau suivant :

| h1/R | h2/R | h3/R |
|---|---|---|
| 0,15 à 0,3 | 0,7 à 1,0 | 1,5 à 2,5 |

Le recours au système de bobines précédent, objet de l'invention, permet de supprimer les termes H31 et H51 du développement analytique du champ, ainsi que tous les termes de degré 3 et de degré 5. On obtient ainsi une variation relative de la linéarité du champ de polarisation respectée à 1% près dans une sphère de rayon égal à 0,4R, R étant le rayon du cylindre sur lequel sont situés les bobinages de gradient.

Selon une première caractéristique importante de l'invention, le système de bobines comporte des nombres de spires N1, N2 dans les arcs aller et N3 dans l'arc retour de chaque motif qui sont choisis parmi le tableau suivant dans lequel on a toujours évidemment N3=-(N1+N2) :

| N1 | N2 | N3 |
|---|---|---|
| 1 | 4 | −5 |
| 1 | 3 | −4 |
| 3 | 8 | −11 |
| 2 | 5 | −7 |
| 3 | 7 | −10 |
| 1 | 2 | −3 |
| 4 | 7 | −11 |
| 3 | 5 | −8 |
| 2 | 3 | −5 |

Ce tableau permet de choisir, sans sortir du cadre de la présente invention, les nombres de spires des arcs aller et retour de chaque motif, étant entendu que l'arc retour comporte toujours un nombre de spires égale à la somme des spires des deux arcs aller.

Selon l'invention également, le système de bobines peut répondre à deux types de structures différentes selon que la section centrale b des arcs de chaque motif est de dimension restreinte ou importante par rapport aux dimensions des sections extrêmes a et c. Une optimisation de chacune de ces deux structures correspond aux valeurs alpha1, alpha2, alpha3, et alpha4 du tableau suivant des angles sous lesquels, depuis l'axe $0_z$, on voit les côtés de chaque motif parallèle à cet axe :

| alpha 1 | alpha 2 | alpha 3 | alpha 4 |
|---|---|---|---|
| 22°–24° | 82°–84° | 96°–98° | 154°–156° |
| 12°–14° | 48°–50° | 130°–132° | 166°–168° |

Les deuxièmes et troisièmes lignes du tableau précédent correspondant respectivement à la première et à la deuxième structure.

Selon l'invention également, la section centrale b de chaque arc de chaque motif peut être obtenu selon deux configurations différentes.

Dans une première configuration qualifiée de "décalée" dans la suite du texte, cette section centrale b résulte du décalage angulaire de deux bobines identiques par rotation autour de l'axe Oz, amenant ces deux bobines symétriquement par rapport au plan xOz, les deux bobines étant de plus en série et parcourues par le même courant.

Selon une seconde configuration qualifiée d'"imbriquée" dans la suite du texte, l'existence de cette section centrale b de chaque arc est obtenue par deux bobines indépendantes, de largeurs différentes, ayant le plan xOz comme plan de symétrie et parcourues par des courants égaux.

Selon une troisième structure de mise en oeuvre du système de bobines objet de l'invention, on réduit à zéro la section centrale b de chaque arc et les angles alpha1 et alpha2 sous lesquels on voit de l'axe Oz les côtés de chaque motif parallèle à cet axe ont des valeurs aussi voisines que possible de celles du tableau suivant :

| alpha 1 | alpha 2 |
|---------|---------|
| 26°–30° | 150°–154° |

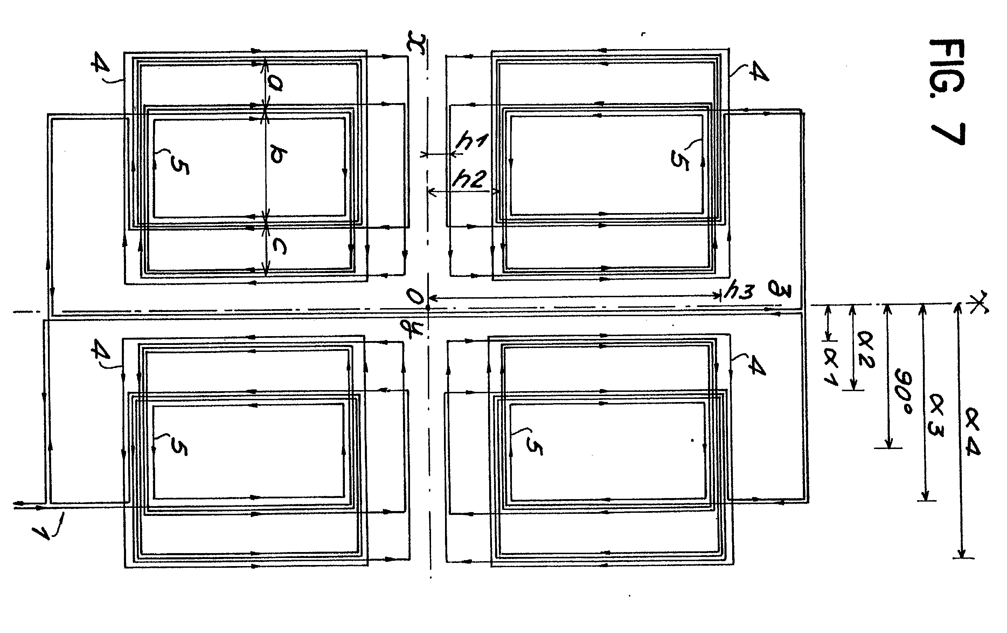

Enfin, selon une variante de la structure 2, correspondant au cas des bobinages décalés l'un par rapport à l'autre dans chaque motif, une spire supplémentaire fermée sur elle-même est prévue le long des arcs 2 et 3, l'une intérieure au motif et l'autre extérieure comme indiqué sur la figure 7.

De toute façon l'invention sera mieux comprise à la lecture de la description de différents exemples donnés ci-après, cette description, fournie à titre indicatif et non limitatif, se réfère aux figures 3 à 9 qui sont une représentation plane du système de bobines objet de l'invention, la surface du cylindre sur lequel les bobines sont placées étant supposée fendue et ouverte selon une génératrice parallèle à l'axe Oz. Sur ces figures :

- la figure 3 montre l'implantation générale des arcs de courant dans les quatre motifs constitutifs du système de bobines objet de l'invention ;
- la figure 4 montre un mode de réalisation de la structure 1 en bobinage dit "décalé" ;
- la figure 5 montre un mode de mise en oeuvre possible de la structure 1 du système de bobines objet de l'invention selon la réalisation dite "bobinage imbriqué" ;
- la figure 6 représente la structure 2 du système de bobines objet de l'invention dans la réalisation du type "bobinage décalé" ;
- la figure 7 représente une variante de la structure 2 précédente en bobinage "décalé" ;
- la figure 8 représente la structure 2 du système de bobines objet de l'invention dans la version dite "bobinage imbriqué" ;
- la figure 9 représente la structure 3 du système de bobines objet de l'invention.

Sur la figure 3 on a représenté schématiquement un système de bobines conformes à l'invention comportant, après mise à plat du cylindre sur lequel les bobines sont placées, les quatre motifs M1, M2, M3 et M4 dont se compose ce système. Conformément à l'invention, ils sont disposés le long des axes Oz correspondant à la direction de la polarisation et Ox, Oy, perpendiculaires deux à deux au précédent. Sur la figure, l'axe Ox est dirigé du centre O vers la gauche, et l'axe Oy est vu de bout au centre de cette même figure.

Selon l'invention, les quatre motifs M1, M2, M3, et M4 sont composés chacun de trois arcs de courant A1, A2, pour le courant aller et A3 pour le courant retour et ils sont symétriques deux à deux d'une part par rapport au plan xOy de la figure 3 et d'autre part par rapport au centre 0 de cette même figure. C'est ainsi que les motifs M1 et M3 d'une part ainsi que M2 et M4 de l'autre, sont symétriques deux à deux par rapport au plan xOy de la figure 3. Par ailleurs, et toujours selon l'invention, les motifs M1 et M4 d'une part et M2 et M3 de l'autre sont également symétriques par rapport au centre O situé sur l'axe Oz au centre de la bobine cylindrique représentée ici sous la forme développée. Les symétries précédentes doivent s'entendre non seulement en ce qui concerne les situations spatiales des différents arcs A1, A2 et A3 de courant dans les bobines, mais également en ce qui concerne le sens de ces courants dans chacun des arcs. Tout ceci est d'ailleurs clairement visible sur le schéma de la figure 3, où l'on s'est contenté de représenter schématiquement les arcs de courant parallèles au plan xOy, c'est-à-dire tracés selon des sections droites du cylindre de rayon R perpendiculaires à l'axe Oz, ces portions de courant étant les seules à participer aux gradients transversaux Gx et Gy que l'on cherche à produire lorsque le champ statique Bo est parallèle à Oz. Sur cette figure 3, on a négligé par simplicité, les parties de conducteurs du système de bobines qui sont parallèles à l'axe Oz et qui servent simplement de liaison entre les arcs A1, A2 et A3 à défaut de produire une composante utile pour les gradients Gx et Gy.

Selon l'invention également, on voit que dans chacun des motifs M1, M2, M3 et M4 les arcs de courants A1, A2 et A3 sont situés à des distances respectives h1, h2, h3 du plan de symétrie xOy de l'ensemble.

Une autre caractéristique essentielle de l'invention apparaît sur cette figure 3 et réside dans le fait que chaque arc de courant A1, A2 et A3 comporte trois sections répertoriées a, b, c dont les deux extrêmes a et c sont parcourues par un courant d'intensité moitié de celui qui parcourt la section centrale b. Ceci est clairement indiqué sur la figure 3 où l'on voit que les courants aller des deux premiers arcs A1 et A2 étant égaux respectivement à I et J dans les sections extrêmes a et c, sont égaux à 2I et 2J dans la section centrale b. Par ailleurs, le courant dans l'arc de retour A3 est égal à I+J pour les sections extrêmes a et c et 2(I+J) pour la section centrale b.

Sur la figure 3, on a également utilisé un système de repérage angulaire des positions des sections a, b et c par rapport au plan vertical yOz, ces coordonnées angulaires des extrémités des trois sections a, b et c étant respectivement désignées par les angles alpha 1, alpha 2, alpha 3, et alpha 4. Le milieu de la section centrale b correspond à la distance angulaire 90° par rapport au plan zOy, ce qui signifie que chacun des motifs M1, M2, M3 et M4 du système de bobines objet de l'invention admet le plan xOz comme plan de symétrie.

Enfin, selon une autre caractéristique également très importante de la présente invention, les rapports h1/R, h2/R et h3/R sont choisis aussi proches que possible des valeurs du tableau suivant :

| h1/R | h2/R | h3/R |
|---|---|---|
| 0,15 à 0,3 | 0,7 à 1,0 | 1,5 à 2,5 |

La figure 3 qui vient d'être décrite permet de définir de la façon la plus générale possible la constitution géométrique et électrique des quatre motifs M1, M2, M3 et M4 constituant les différents systèmes de bobines conformes à la présente invention.

On notera encore que le système de bobines objet de l'invention réalise les lignes de courant telles qu'elles sont représentées sur la figure 3 précédente en utilisant un nombre de spires N1, N2, N3 pour les trois arcs A1, A2, A3 de chaque motif, le nombre de ces spires étant à chaque fois doublé dans la section centrale b pour obtenir le doublement de l'intensité correspondante. En pratique d'ailleurs, comme on le verra dan les figures qui suivent, les quatre motifs sont parcourus par la même intensité électrique en série et c'est le choix du nombre de spires respectives N1, N2, N3 qui permet de réaliser les condition souhaitées.

A ce sujet d'ailleurs, il faut noter que les nombres de spires N1 et N2 dans les arcs aller et N3 dans l'arc retour de chaque motif sont choisis dans le tableau suivant, dans lequel pour chaque famille de valeur on a N3=-(N1+N2) :

| N1 | N2 | N3 |
|---|---|---|
| 1 | 4 | −5 |
| 1 | 3 | −4 |
| 3 | 8 | −11 |
| 2 | 5 | −7 |
| 3 | 7 | −10 |
| 1 | 2 | −3 |
| 4 | 7 | −11 |
| 3 | 5 | −8 |
| 2 | 3 | −5 |

Dans les réalisations pratiques, un certain nombre de modes de mises en oeuvre, sont possibles, et ils seront décrits maintenant en se référant aux figures suivantes.

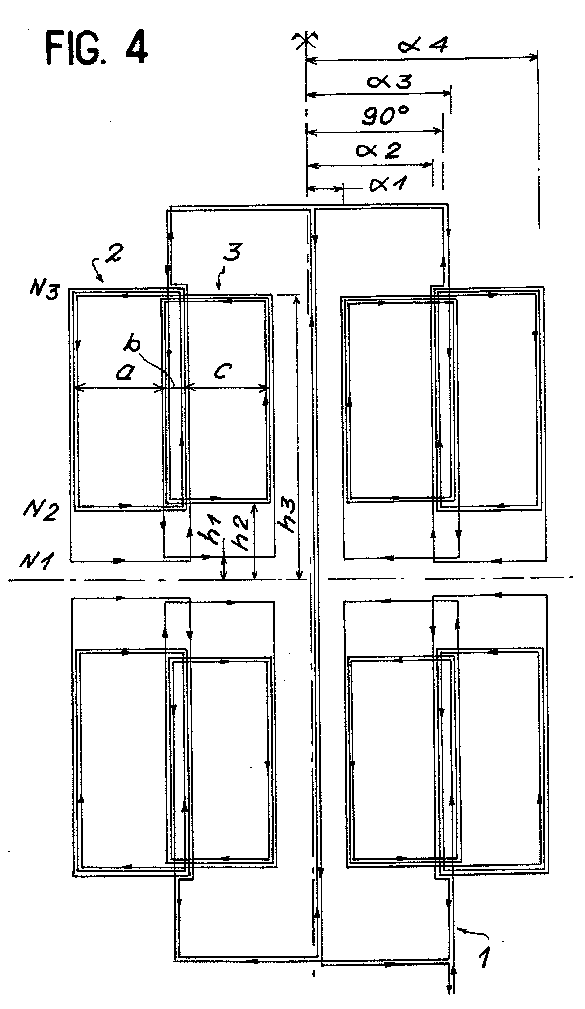

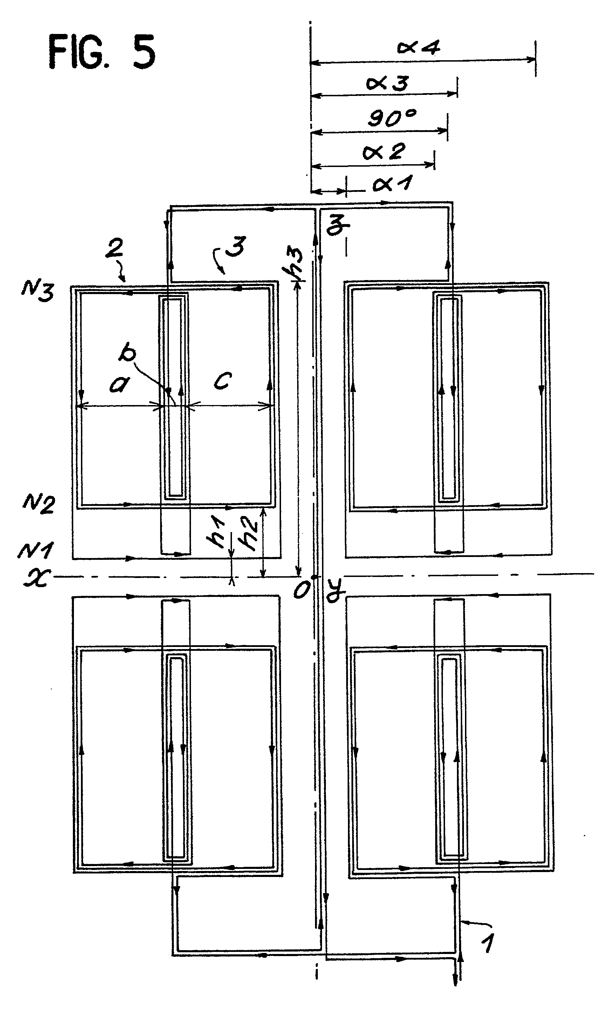

Sur les figures 4 et 5 suivantes, on décrit des modes de mise en oeuvre de la structure n°1 selon l'invention, dans laquelle la section centrale b de chaque motif est de dimensions restreintes par rapport aux sections extrêmes a et c, ce qui conduit pour les angles alpha 1, alpha 2, alpha 3 et alpha 4 à des valeurs aussi voisines que possible de celles du tableau suivant :

| alpha 1 | alpha 2 | alpha 3 | alpha 4 |
|---------|---------|---------|---------|
| 22°–24° | 82°–84° | 96°–98° | 154°–156° |
| 12°–14° | 48°–50° | 130°–132° | 166°–168° |

Sur les figures 4 et 5, le courant entre et sort en 1 et parcourt en série les quatre motifs M1, M2, M3 et M4 selon le dessin à chaque fois représenté. Le mode de mise en oeuvre représenté sur ces deux dessins correspond à N1=1, N2=2, N3=-3.

Dans l'exemple de structures n°1 représenté sur la figure 4, le bobinage comporte quatre motifs M dont chacun est du type "décalé", ce qui signifie que la section centrale b de chacun des arcs est obtenue à l'aide de deux bobines telles que 2 et 3 dans la partie gauche de la figure 4, décalées angulairement par rotation autour de Oz jusqu'à être symétriques par rapport au plan xOz, et parcourues en série par le même courant.

Dans la structure de type 1 imbriquée rprésentée sur la figure 5, la section centrale b de chaque arc est obtenue par deux bobines indépendantes de largeurs différentes qui ont le plan xOz comme plan de symétrie et sont parcourues par des courants égaux. Il est clair que les deux dessins des lignes de courant des structures de type 1 des figures 4 et 5 sont strictement équivalents au point de vue des champs transversaux créés et donc des gradients Gx et Gy obtenus.

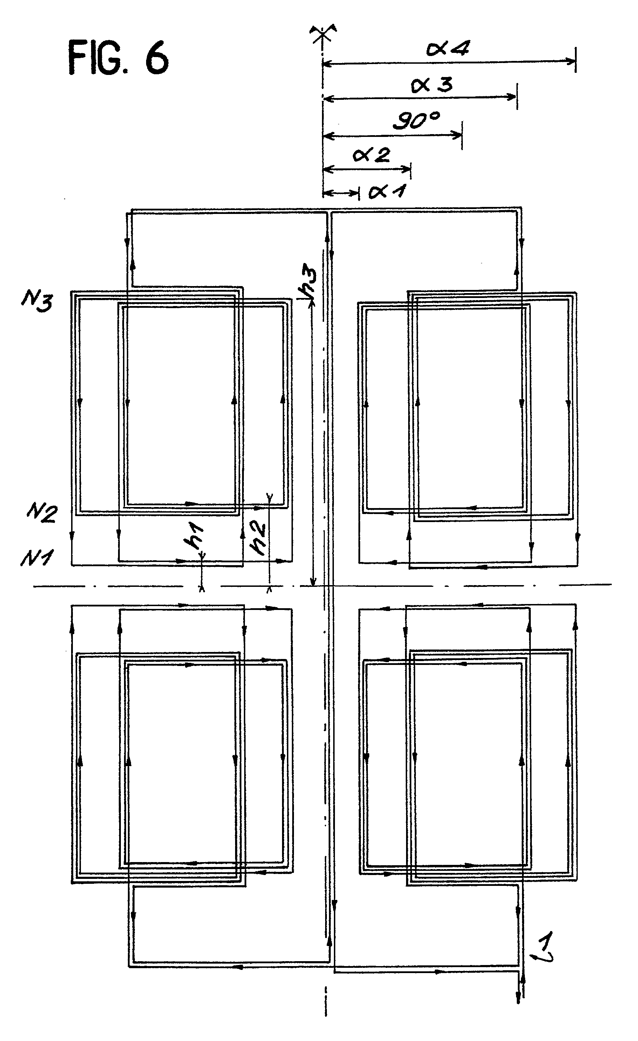

Sur les figures 6, 7 et 8, on a représenté des structures de type 2 du système de bobines objet de l'invention dans lesquelles la valeur de la section centrale b de chacun des motifs M1, M2, M3 et M4, est plus importante que la valeur des sections extrêmes a et c. Dans ces trois réalisations, les angles alpha 1, alpha 2, alpha 3 et alpha 4, précédemment définis ont des valeurs qui se situent de façon aussi voisines que possible à celles du tableau suivant:

| alpha 1 | alpha 2 | alpha 3 | alpha 4 |
|---------|---------|---------|---------|
| 12°–14° | 48°–50° | 130°–132° | 166°–168° |

Les structures de type 2 des figures 6 et 7 correspondent à un système de bobinage du type "décalé" comme il a déjà été expliqué précédemment, c'est-à-dire dans lequel chaque motif comporte deux demi bobines décalées symétriquement par rapport au plan xOz. Dans le cas de la structure de type 2 de la figure 7, on a représenté une variante dans laquelle, autour de chacun des motifs M1, M2, M3, M4, on a ajouté une boucle fermée sur elle-même et référencée 4 pour celle qui entoure complètement chaque motif à l'extérieur de celui-ci et 5 pour celle qui entoure seulement la section centrale de ces mêmes motifs. Dans le cas particulier de la structure de la figure 7, on a donc utilisé des nombres de spires N1=1, N2=3 et N3=-4.

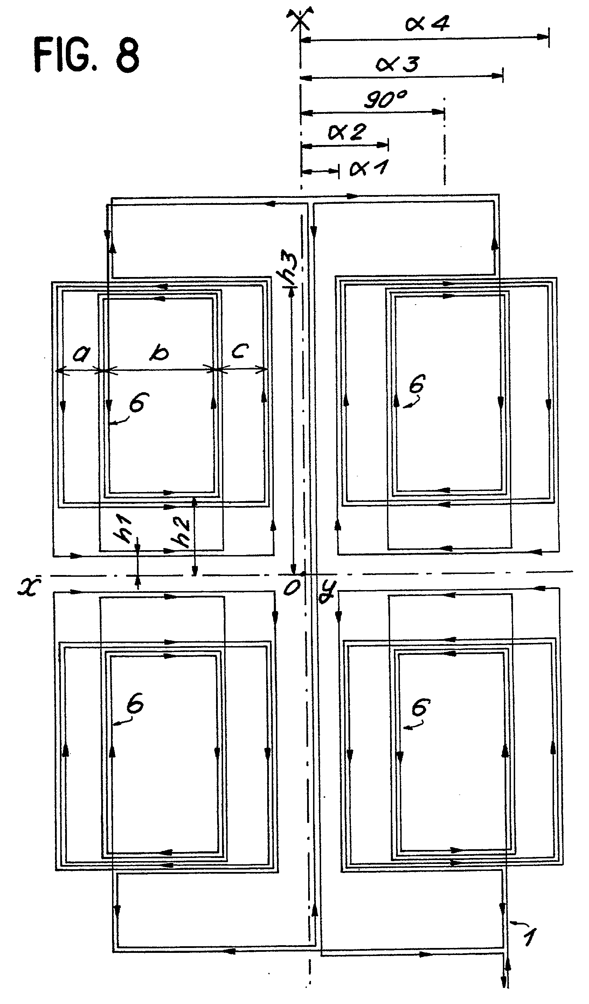

Sur la figure 8, on a représenté une structure du type n°2 conforme à l'invention utilisant un bobinage "imbriqué" dans lequel comme sur les figures précédentes, le courant entre et sort en 1. Sur cette structure N°2 de la figure 8, la section centrale b est réalisée comme dans le cas de la figure 5 par une bobine centrale indépendante 6.

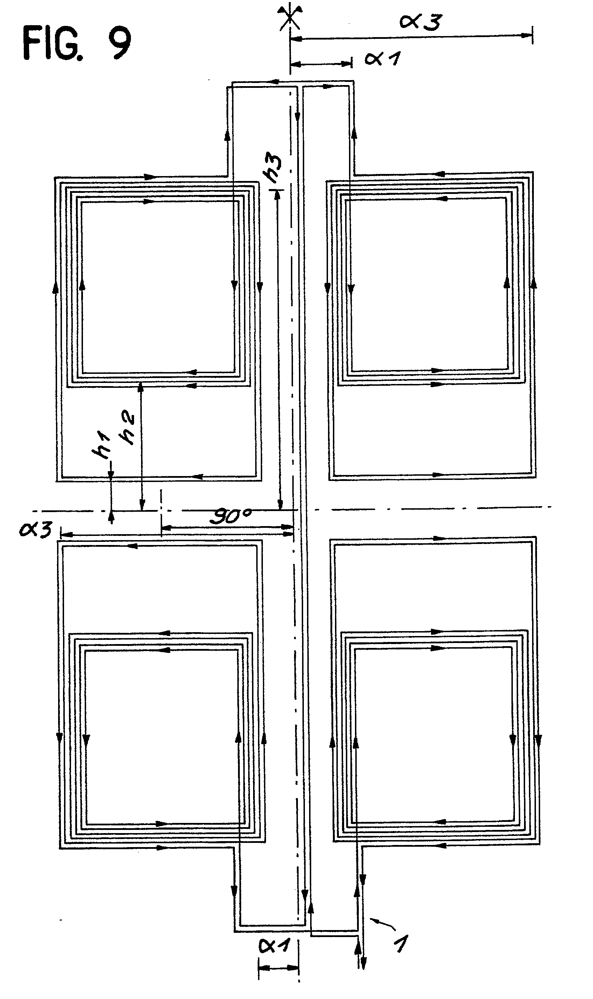

Sur la figure 9 enfin, on a représenté un exemple de la structure n°3 du système de bobines objet de l'invention correspondant au cas dans lequel la section centrale b de chacun des arcs A1, A2 et A3 est réduite à zéro et les angles alpha 1 et alpha 2 sous lesquels on voit depuis l'axe Oz et les côtés de chaque motif parallèle à cet axe ont des valeurs aussi voisines que possible de 26° à 30° pour alpha 1 et 150° à 154° pour alpha 2. Sur cette figure 9, les entrées et sorties de courant ont toujours lieu en 1 et les nombres de spires de chacun des arcs sont respectivement N1=2 et N2=4 et N3=-6. Cette structure, de réalisation incontestablement plus simple que celle des figures précédentes, résulte en fait du passage à la limite de la structure N°1 du type bobinage décalé de la figure 4 dans laquelle on a étiré complètement les deux demi-bobines 2 et 3 et supprimé la ligne de courant centrale dans laquelle l'intensité globale est nulle par définition. A l'aide de la structure n°3 de la figure 9 on obtient certes une linéarité un peu moins grande des gradients transversaux Gx et Gy, mais néanmoins très suffisante encore pour obtenir de bonnes images ou des analyses spectroscopiques correctes dans de nombreuses applications.

Les gradients transversaux obtenus par les différentes structures décrites précédemment, sont corrigés des termes de cinquième ordre et de cinquième degré, de cinquième ordre et de troisième degré, de cinquième ordre et de premier degré, de troisième ordre et de troisième degré, de troisième ordre et de premier degré, si l'on se réfère à l'expression analytique de leur grandeur à l'aide de développements utilisant la méthode des polynômes de Legendre.

## Revendications

1. Système de bobines, pour la production en imagerie, en spectroscopie ou en imagerie spectroscopique par résonance magnétique nucléaire de gradients Gx, Gy de champs magnétiques de polarisation très uniformes selon une direction perpendiculaire (Ox ou Oy) au champ magnétique de polarisation créé dans la direction Oz par un aimant d'accès axial, ledit système de bobines étant disposé sur la surface externe d'un cylindre droit de révolution d'axe Oz et de rayon R, comprenant quatre motifs de fils conducteurs symétriques deux à deux par rapport à un centre 0 et deux à deux par rapport au plan vertical xoy, chaque motif comportant des arcs ou lignes de courant disposés selon des portions de sections circulaires du cylindre droit, caractérisé par le répertition suivante :

- chaque motif comporte trois arcs participant à la création du gradient recherché, à savoir deux arcs "aller" situés près du centre 0 aux distances respectives $h_1$ et $h_2$ du plan xoy et un arc "retour" plus éloigné du centre 0 et situé à la distance $h_3$ du plan xoy ;

- chaque arc comporte trois sections a, b, c dont les deux extrêmes a et c d'égale longueur sont parcourues par un courant d'intensité moitié de celui qui parcourt la section centrale b, les courants "aller" dans la première section des deux premiers arcs étant égaux respectivement à I et J et le courant "retour" dans la première section du troisième arc étant égal à I+J ;

- en ce que les rapports $h_1/R$, $h_2/R$ et $h_3/R$ sont choisis aussi proches que possible des valeurs du tableau suivant :

| $h_1/R$ | $h_2/R$ | $h_3/R$ |
|---|---|---|
| 0,15 à 0,3 | 0,7 à 1,0 | 1,5 à 2,5 |

2. Système de bobines selon la revendication 1, caractérisé en ce que les nombres de spires N1 et N2 dans les arcs "aller" et N3 dans l'arc "retour" de chaque motif, sont choisis dans le tableau suivant dans lequel, pour chaque famille de valeurs, on a N3=-(N1+N2) :

| N1 | N2 | N3 |
|---|---|---|
| 1 | 4 | −5 |
| 1 | 3 | −4 |
| 3 | 8 | −11 |
| 2 | 5 | −7 |
| 3 | 7 | −10 |
| 1 | 2 | −3 |
| 4 | 7 | −11 |
| 3 | 5 | −8 |
| 2 | 3 | −5 |

3. Système de bobines selon l'une quelconque des revendications 1 et 2 précédentes, caractérisé en ce que les angles alpha 1, alpha 2, alpha 3 et alpha 4 sous lesquels on voit de l'axe Oz les côtés de chaque motif parallèles à cet axe ont des valeurs choisies aussi voisines que possible de celles du tableau suivant :

| alpha 1 | alpha 2 | alpha 3 | alpha 4 |
|---|---|---|---|
| 22°–24° | 82°–84° | 96°–98° | 154°–156° |
| 12°–14° | 48°–50° | 130°–132° | 166°–168° |

4. Système de bobines selon l'une quelconque des revendications 1 à 3, caractérisé en ce que la section centrale b de chaque arc est obtenue par deux bobine identiques décalées en rotation autour de Oz symétriquement par rapport au plan xOz angulairement et parcourues en série par le même courant.

5. Système de bobines selon l'une quelconque des revendications 1 à 3, caractérisé en ce que la section centrale b de chaque trajet est obtenue par deux bobines imbriquées indépendantes de largeurs différentes, ayant le plan xOz comme plan de symétrie et parcourues par des courants égaux.

6. Système de bobines selon l'une quelconque des revendications 1 et 2, caractérisé en ce que l'étendue de la section centrale b de chaque arc est réduite à zéro et les angles alpha 1, alpha 2, sous lequels on voit de l'axe Oz les côtés de chaque motif parallèles à cet axe ont des valeurs aussi voisines que possible de celles du tableau suivant :

| alpha 1 | alpha 2 |
|---------|---------|
| 26°–30° | 150°–154° |

7. Système de bobines selon l'une quelconque des revendications 1 à 4 précédentes, caractérisé en ce que leurs quatre motifs sont parcourus par la même intensité en série et que les intensités I et J désirées en chaque point du circuit sont réalisées par le choix de leur nombre de spires respectives N1, N2 et N3.

**Patentansprüche**

1. Spulensystem zur Erzeugung bei der Bilddarstellung, bei der Spektroskopie oder bei der spektroskopischen Bilddarstellung durch Kernspinresonanz von magnetischen Feldgradienten $G_X$, $G_Y$ mit sehr gleichmäßiger Polarisation entlang einer Richtung senkrecht ($o_x$ oder $o_y$) zum magnetischen Polarisationsfeld, das in der Richtung Oz mit dem Radius R gedrehten Zylinders angeordnet ist und vier Einheiten von Leitern, die in Zweiereinheiten bezüglich des Ursprungs O und in Zweiereinheiten bezüglich der vertikalen Ebene symmetrisch sind, umfaßt, wobei jede Einheit Strombögen oder -pfade aufweist, die entlang von Teilen kreisförmiger Abschnitte des geraden Zylinders angeordnet sind, gekennzeichnet durch die folgende Einteilung:
– jede Einheit umfaßt drei Bögen, die bei der Bildung des gesuchten Gradienten mitwirken, d.h. zwei "Hin-" Bögen, die sich in der Nähe des Ursprungs O mit den jeweiligen Abständen $h_1$ und $h_2$ von der Ebene xoy befinden, und einen "Zurück-" Bogen, der weiter von Ursprung O entfernt in einem Abstand $h_3$ von der Ebene xoy angeordnet ist;
– jeder Bogen umfaßt drei Abschnitte a, b, c, von denen die beiden äußeren a und c von gleicher Länge von einem Strom von der halben Stärke dessen, der durch den mittleren Abschnitt b fließt, durchflossen werden, wobei die "Hin-" Ströme im ersten Abschnitt der beiden ersten Bögen jeweils gleich I und J sind und der "Zurück-" Strom im ersten Abschnitt des dritten Bogens gleich I + J ist;
– und dadurch, daß die Verhältnisse $h_1/R$, $h_2/R$ und $h_3/R$ so nahe wie möglich aus den Werten der folgenden Tabelle gewählt sind:

| $h_1/R$ | $h_2/R$ | $h_3/R$ |
|---------|---------|---------|
| 0,15 bis 0,3 | 0,7 bis 1,0 | 1,5 bis 2,5 |

2. Spulensystem nach Anspruch 1, dadurch gekennzeichnet, daß die Zahlen $N_1$ und $N_2$ der Wicklungen in den "Hin-" Bögen und $N_3$ in dem "Zurück-" Bogen jeder Einheit, aus der folgenden Tabelle ausgewählt sind, in der man für jede Wertegruppe $N_3 = -(N_1+N_2)$ hat:

| N1 | N2 | N3 |
|----|----|-----|
| 1 | 4 | –5 |
| 1 | 3 | –4 |
| 3 | 8 | –11 |
| 2 | 5 | –7 |
| 3 | 7 | –10 |
| 1 | 2 | –3 |
| 4 | 7 | –11 |
| 3 | 5 | –8 |
| 2 | 3 | –5 |

3. Spulenanordnung nach einem der vorhergehenden Ansprüche 1 und 2, dadurch gekennzeichnet, daß die Winkel alpha 1, alpha 2, alpha 3 und alpha 4, unter denen man von der Achse Oz die zu dieser Achse parallelen Seiten jeder Einheit sieht, Werte besitzen, die so nahe wie möglich bei denen der folgenden Tabelle ausgewählt werden:

| alpha 1 | alpha 2 | alpha 3 | alpha 4 |
|---------|---------|---------|---------|
| 22°–24° | 82°–84° | 96°–98° | 154°–156° |
| 12°–14° | 48°–50° | 130°–132° | 166°–168° |

4. Spulenanordnung nach einem der Ansprüche 1 bis 3, dadurch gekennzeichnet, daß der mittlere Abschnitt b jedes Bogens aus zwei identischen Spulen erhalten wird, die durch Drehung winkelmäßig um Oz und symmetrisch bezüglich der Ebene xOz versetzt sind und in Reihe von demselben Strom durchflossen werden.

5. Spulenanordnung nach einem der Ansprüche 1 bis 3, dadurch gekennzeichnet, daß der mittlere Abschnitt b jedes Bogens aus zwei verschachtelten, unabhängigen Spulen unterschiedlicher Größe erhalten wird, die die Ebene xOz als Symmetrieebene besitzen und von gleichen Strömen durchflossen werden.

6. Spulenanordnung nach einem der Ansprüche 1 und 2, dadurch gekennzeichnet, daß die Ausdehnung des zentralen Abschnitts b jedes Bogen auf null reduziert ist und daß die Winkel alpha 1, alpha 2, unter denen man von der Achse Oz die zu dieser Achse parallelen Seiten jeder Einheit sieht, Werte besitzen, die so nahe wie möglich bei denen der folgenden Tabelle liegen:

| alpha 1 | alpha 2 |
|---------|---------|
| 26°–30° | 150°–154° |

7. Spulenanordnung nach einem dor vorhergehenden Ansprüche 1 bis 4, dadurch gekennzeichnet, daß ihre vier Einheiten von derselben Stärke in Reihe durchflossen werden und das die Intensitäten I und J in jeder Punkt des Schaltkreises durch die Wahl ihrer jeweiligen Zahl von Wicklungen $N_1$, $N_2$ und $N_3$ verwirklicht werden.

## Claims

1. System of coils for producing in imaging, spectroscopy or spectroscopic imaging by nuclear magnetic resonance, gradients $G_Z$, $G_Y$ of magnetic polarization fields which are very uniform in a direction (Ox or Oy) perpendicular to the magnetic polarization field produced in direction Oz by an axial access magnet, whereby said system of coils is placed on the outer surface of a straight cylinder of revolution of axis Oz and radius R comprising four patterns of conductor wires pairwise symmetrical with respect to a centre 0 and pairwise symmetrical with respect to the vertical plane xoy, each pattern having current lines or arcs disposed in accordance with circular section portions of the straight cylinder, characterized by the following distribution:

– each pattern has three arcs participating in the production of the sought gradient, namely two "outward" arcs located close to centre 0 at respective distances $H_1$ and $H_2$ from plane xoy and one "return" arc further from centre 0 and located at distance $H_3$ from plane xoy;

– each arc has three sections a, b and c, whereof the two end sections a and c of equal length are traversed by a current having an intensity half that of the current passing through the central section b, the "outward" currents in the first section of the first two arcs being respectively equal to I and J and the "return" current in the first section of the third arc being equal to I+J;

– and the ratios $h_1/R$, $h_2/R$ and $h_3/R$ are made as close as possible to the values of the following table:

| h1/R | h2/R | h3/R |
|------|------|------|
| 0.15 to 0.3 | 0.7 to 1.0 | 1.5 to 2.5 |

2. System of coils according to claim 1, characterized in that the number of turns $N_1$ and $N_2$ in the "outward" arcs and $N_3$ in the "return" arc of each pattern are chosen in the following table in which for each group of values, there is $N_3=-(N_1+N_2)$:

| N1 | N2 | N3 |
|----|----|-----|
| 1 | 4 | −5 |
| 1 | 3 | −4 |
| 3 | 8 | −11 |
| 2 | 5 | −7 |
| 3 | 7 | −10 |
| 1 | 2 | −3 |
| 4 | 7 | −11 |
| 3 | 5 | −8 |
| 2 | 3 | −5 |

3. System of coils according to either of the claims 1 and 2, wherein the angles alpha 1, alpha 2, alpha 3 and alpha 4 under which is seen from axis Oz the sides of each pattern parallel to said axis have values which are as close as possible to these of the following table:

| alpha 1 | alpha 2 | alpha 3 | alpha 4 |
|---------|---------|---------|---------|
| 22°–24° | 82°–84° | 96°–98° | 154°–156° |
| 12°–14° | 48°–50° | 130°–132° | 166°–168° |

4. System of coils according to any one of the claims 1 to 3, characterized in that the central section b of each arc is obtained by two identical coils angularly displaced by rotation about axis Oz symmetrically with respect to plane xOz and traversed in series by the same current.

5. System of coils according to any one of the claims 1 to 3, characterized in that the central section b of each path is obtained by two independent imbricated coils of different widths, having the plane xOz as the plane of symmetry and traversed by equal currents.

6. System of coils according to either of the claims 1 and 2, characterized in that the length of central section b of each arc is reduced to zero and the angles alpha 1 and alpha 2 under which from axis Oz are seen the sides of each pattern parallel to said axis have values which are as close as possible to those of the following table:

| alpha 1 | alpha 2 |
|---------|---------|
| 26°–30° | 150°–154° |

7. System of coils according to any one of the claims 1 to 4, characterized in that the four patterns thereof are traversed by the same intensity in series and the desired intensities I and J at each point of the circuit are obtained by the choice of the number of respective turns thereof $N_1$, $N_2$ and $N_3$.

11

FIG. 1

FIG. 2

FIG. 3

# FIG. 4

FIG. 5

FIG. 6

EP 0 243 270 B1

FIG. 7

# FIG. 8

# FIG. 9